# EUROPÄISCHE PATENTSCHRIFT

(11) **EP 0 854 495 B1**
(45) Veröffentlichungstag und Bekanntmachung des Hinweises auf die Patenterteilung: **03.09.2003**
(21) Anmeldenummer: 97121756.7
(22) Anmeldetag: 10.12.1997
(51) Int. Cl.: H01J 49/48, H01J 37/252

(54) **Vorrichtung und Verfahren zum betrieb eines Spektrometers mit Energie- und Winkel-auflösung**
Method and apparatus related to the use of a spectrometer with energy resolution and angular resolution
Dispositif et méthode de mise en oeuvre d'un spectromètre avec résolution en énergie et résolution angulaire

(30) Priorität: 15.01.1997 DE 19701192
(43) Veröffentlichungstag der Anmeldung: 22.07.1998
(73) Patentinhaber: Staib Instrumente GmbH, 85416 Langenbach (DE)
(72) Erfinder: Staib, Philippe, Dr., 85416 Langenbach (DE)
(74) Vertreter: Hertz, Oliver, Dr.

(56) Entgegenhaltungen:
- EP-A- 0 488 067
- PATENT ABSTRACTS OF JAPAN vol. 007, no. 170 (E-189), 27.Juli 1983 & JP 58 075754 A (SHIMAZU SEISAKUSHO KK), 7.Mai 1983,
- A. CLARKE: "Wave-vector imaging photoelectron spectrometer." REVIEW OF SCIENTIFIC INSTRUMENTS., Bd. 58, Nr. 8, August 1987, NEW YORK US, Seiten 1439-1444, XP002056850
- YOSHIMI HORIO: "Zero-loss reflection high-energy electron diffraction patterns and rocking curves of the Si(111) 7x7 surface obtained by energy filtering." JAPANESE JOURNAL OF APPLIED PHYSICS., Bd. 35, 1966, TOKYO JP, Seiten 3559-3564, XP002056851

## Beschreibung

Die Erfindung betrifft Vorrichtungen und Verfahren zur Abbildung eines Teilchenstrahls, der geladene Teilchen mit einer bestimmten Energie- und Winkelverteilung umfaßt, auf Detektormitteln, und Spektrometer mit Energie- und Winkelauflösung.

Bei Bestrahlung von Materie kann es durch Wechselwirkungsvorgängen zur Abstrahlung von Teilchen von einem Wechselwirkungsbereich kommen. Aufgrund der Raum- (oder Winkel-) und Energieverteilung der abgestrahlten Teilchen lassen sich Rückschlüsse auf physikalische oder chemische Vorgänge bei der Wechselwirkung oder auf Merkmale der beteiligten Teilchensorten oder des Wechselwirkungsbereichs ziehen. Entsprechend wurden zahlreiche Analyseverfahren z. B. unter Verwendung von Elektronenbeugungsuntersuchungen oder spektroskopischen Untersuchungen entwickelt.

Ein Problem der bekannten Analyseverfahren ist die gleichzeitige Erfassung der Winkel- und der Energieverteilung eines Teilchenstrahls (z. B. Elektronen, Ionen oder Ionengruppen, Atome oder Atomgruppen).

Bei Elektronenbeugungsuntersuchungen (z. B. RHEED) besteht beispielsweise ein Interesse daran, die Aufnahme von Beugungsbildern mit einer Energiefilterung zu verbinden, um elastische und unelastische Streuvorgänge zu trennen. Die Modellierung der elastischen Streuungen erlaubt eine verbesserte Strukturauflösung. Ferner besteht ein Interesse an winkelaufgelöster Augerelektronen-Spektroskopie.

Bekannte Systeme zur simultanen Orts- und Energieauflösung bei der Elektronenbeugung lassen sich in zwei Gruppen unterteilen.

Eine erste Bauform arbeitet mit der Kombination einer herkömmlicher Abbildung auf einen Leuchtschirm mit einem Rastermechanismus, der eine Abtastung von Ausschnitten des Beugungsbildes und deren Energieanalyse erlaubt. Der Rastermechanismus kann entweder eine Ablenkeinrichtung für das Beugungsbild oder ein im Beugungsbild bewegliches Sensorelement (sog. Channeltron) umfassen. Derartige Systeme sind jedoch nachteilig, da sie einen komplizierten Aufbau aufweisen und nur eine quasi-simultane Orts- und Energieauflösung erlauben. Der Betrieb des Rastermechanismus ist zeitaufwendig, so daß Echtzeitanalysen z. B. bei Oberflächenveränderungen an Festkörpern nur eingeschränkt möglich sind.

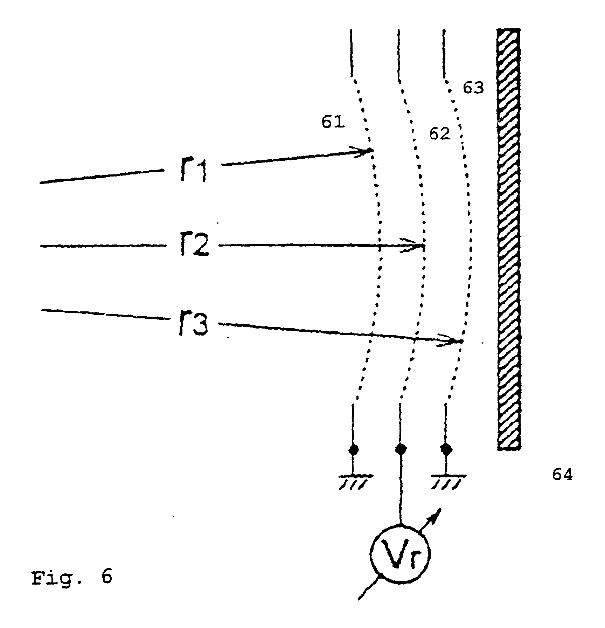

Bei einer zweiten Bauform wird das Beugungsbild durch Kugelgitter beobachtet, die zur Energiefilterung vorgesehen sind. Ein derartiges System wird z. B. von Y. Horio in Jpn. J. Appl. Phys. (Bd. 35, 1996, S. 3559 ff.) für RHEED-Untersuchungen beschrieben und im folgenden unter Bezug auf Figur 6 erläutert.

Figur 6 zeigt den Einsatz von drei sphärischen Gittern oder Kugelgittern 61, 62 und 63 vor einem Beobachtungsschirm 64 in einer bekannten RHEED-Apparatur. Die Kugelgitter sind als Energiefilter zum Abschirmen (Absaugen) inelastisch gestreuter Elektronen vorgesehen. Zwischen den Gittern 61 und 62 ist ein Abbremspotential Vᵣ angelegt. Das Gitter 63 dient der Korrektur der Abbildung auf den Schirm 64. Die Gitter sind mit den Abständen r₁, r₂ und r₃ konzentrisch so angeordnet, daß sich die Probe im Mittelpunkt der Gittersphären befindet.

Die Energiefilterung mit Kugelgittern besitzt die folgenden Nachteile.

Der Aufbau erfordert, daß sich der abgebildete Bereich einer Probe, von dem das Beugungsbild ausgeht, im Mittelpunkt der Kugelgitter befindet. Daher ist zur Realisierung praktikabler Bildausschnitte und/oder Baugrößen ein kleiner Arbeitsabstand (rund 20 bis 30 mm) zwischen der Probe und dem Analysator (Eintrittsfenster) erforderlich. Der Arbeitsabstand ist durch die Gitterradien unveränderlich festgelegt.

Der kleine Arbeitsabstand führt im Einsatz z. B. in Beschichtungsanlagen erstens zu Platzproblemen und zweitens zu unakzeptablen Verunreinigungen der Kugelgitter. Die Verunreinigungen werden dadurch verursacht, daß sich im Bereich der Kugelgitter wegen des kleinen Arbeitsabstands ein Partialdruck der abzuscheidenden Substanzen ausbilden und ein Niederschlag auf den Gittern und Isolatoren entstehen kann.

Kugelgitteranalysatoren sind ferner auf kleinste Gitteröffnungen beschränkt, falls praktisch interessante Energieauflösungen von ΔE/E<10⁻² erreichbar sein sollen. Da der Arbeitsabstand als feldfreier Raum fest vorgegeben ist, kann eine Abbremsung (Energieselektion) erst im Bereich der Kugelgitter über eine kurze Strecke stattfinden. Das Abbremspotential muß voll an die Kugelgitter angelegt werden. Damit dennoch eine genügende Energieauflösung erreicht wird, müssen die Gitteröffnungen sehr klein sein (Größenordnung unterhalb 40 µm). Dies ist nachteilig für die Transmissivität der Gitter.

Ferner erfordern Kugelgitteranalysatoren für eine verzerrungsfreie Projektion auf einen ebenen Bildschirm den Einsatz von mindestens 3 Gittern. Dies führt zu einem weiteren Transmissivitätsverlust und so zu einer Transmissivität der Gesamtabbremsanordnung von rund 30 %. Dies ist nachteilig für die Analysenempfindlichkeit.

Neben dem Platzmangel besteht in Beschichtungsanlagen (z. B. MBE-Kammern) oft das Problem, das häufig durch die gegebenen Ansatzflansche an der Kammer keine optimale Analysatorposition erreichbar ist. Der Einsatz der Kugelgitteranalysatoren mit einer präzisen Zentrierung relativ zur Probe ist nur beschränkt möglich.

Aus JP 58-075754-A ist ein Energieanalysator für geladene Teilchen bekannt, bei dem die Probe im Fokus eines sphärischen Reflektors angeordnet ist, der die von der Probe radial ausgehenden Teilchen auf parallele Teilchenbahnen führt. Ein Niedrigenergie-Photoelektronen-Spektrometer wird von A. Clarke et al. in "Review of Scientific Instruments", Bd. 58, 1987, Seite 1439 ff., beschrieben.

Die Aufgabe der Erfindung ist es, verbesserte Vorrichtungen und Verfahren zur winkel- und energieauflösenden Abbildung eines Teilchenstrahls anzugeben, die einen vergrößerten Arbeitsabstand eines Detektors von einer Probe bei hoher Energieauflösung und Empfindlichkeit aufweisen. Es ist ferner Aufgabe der Erfindung, ein entsprechend ausgestattetes Spektrometer und Verfahren zu dessen Betrieb und Verwendung anzugeben.

Diese Aufgabe wird durch eine Vorrichtung, ein Spektrometer und die Verfahren mit den Merkmalen der Gegenstände von Patentanspruch 1, 8, 9 bzw. 11 gelöst. Vorteilhafte Ausführungsformen ergeben sich aus den abhängigen Ansprüchen.

Der Erfindung liegt die Idee zugrunde, bei einer Vorrichtung zur Abbildung eines Teilchenstrahls mit geladenen Teilchen einer bestimmten Energie- und Winkelverteilung auf einem Detektormittel, den von einer Probe ausgehenden Teilchenstrahl (oder Teilchenbündel) zunächst durch Ablenkmittel derart zu beeinflussen, daß sich im wesentlichen parallele, gerade Teilchenbahnen ausbilden, die dann auf eine energieselektive Elektrodenanordnung mit teildurchlässigen Elektroden gerichtet werden. Die Elektrodenanordnung bildet einen Gegenfeldanalysator, der im Fall von Elektronenbeugunguntersuchungen der Filterung inelastischer Streuungen dient. Die gegenseitige Anordnung der parallelen Teilchenbahnen enthält die volle Information der Winkelverteilung des ursprünglichen Teilchenstrahls.

Die erfindungsgemäß vorgesehenen Ablenkmittel erlauben es, den Arbeitsabstand zwischen der Probe und einem Detektormittel gegenüber den herkömmlichen Kugelgitteranalysatoren erheblich zu erhöhen. Dies ist gleichzeitig mit Vorteilen in Bezug auf die Empfindlichkeit und das Auflösungsvermögen verbunden, die im einzelnen unten dargestellt sind.

Die Ablenkmittel umfassen eine Vielzahl von elektromagnetischen Linsen oder anderen geeigneten Elektroden, die in Strahlrichtung derart mit steigenden Bremspotentialen beaufschlagt werden, daß der Teilchenstrahl mit zunächst divergenten Teilchenbahnen in einen Teilchenstrahl mit parallelen Bahnen umgewandelt wird, in deren Verlauf die Teilchen abgebremst und auf die energieselektive Elektrodenanordnung gerichtet werden. Die Ablenkmittel werden auch als Abbremslinsen bezeichnet.

Die Abbremslinsen besitzen mindestens zwei feldformende Elemente (Elektroden), die in Strahlrichtung mit steigenden Abbremspotentialen beaufschlagt sind. Es sind vorzugsweise drei feldformende Elemente vorgesehen. Mit dem in Strahlrichtung dritten Element sind Randstrahlen besser erfaßbar (Randstrahlkorrektur). Es können aber auch mehr Elemente vorgesehen sein.

Die Potentiale, mit denen die Elemente der Abbremslinse beaufschlagt werden, können vom Fachmann mit Kenntnissen der Elektrostatik (z.B. zur Feldverteilung an Zylinderlinsen) in Abhängigkeit von der konkreten Bauform und der erforderlichen Genauigkeit berechnet oder durch geeignete numerische Simulation ermittelt werden. Für übliche Analyseanwendungen z. B. bei RHEED-Untersuchungen soll die nach der Parallelisierung verbleibende Divergenz der Teilchenbahnen weniger als 0,5° betragen.

Das erfindungsgemäße Durchlaufen des Teilchenstrahls durch das Feld der Abbremslinse erfüllt eine Doppelfunktion. Erstens wird ein Beugungsbild mit parallelen Teilchenbahnen (sog. "paralleles Beugungsbild") geformt. Zweitens werden die Teilchen abgebremst. Die Abbremsung ist vorzugsweise so stark, daß die Teilchen beim Eintreffen bei der energieselektiven Elektrodenanordnung eine möglichst geringe Energie besitzen. So soll die Feldstärke am Ort der energieselektiven Elektrodenanordnung möglichst gering sein, um eine verbesserte Energieauflösung zu erhalten. Falls z. B. Elektronenbeugungsuntersuchungen mit einem Elektronenstrahl von anfänglich rund 15 keV durchgeführt werden, so wird eine Abbremsung um 90 % angestrebt. Dies führt zu einer rund 10-fachen Verbesserung der Energieauflösung. Dieses Verhalten ist für Elektronen und Ionen oder andere geladene Teilchen gleich.

Durch die Abbremsung kann bei Erzielung von genügenden Energieauflösungen die Größe der Gitteröffnungen optimiert werden. Andererseits kann bei der Beugung niederenergetischer Elektronen eine schwächere Abbremsung vorgesehen sein.

Die zwei teildurchlässigen, vorzugsweise gitterförmigen, Elektroden (sog. Filterelektroden) sind mit einer Potentialdifferenz (Filter-Abbremspotential) zur Bildung eines Abbremsfeldes derart beaufschlagt, daß Teilchen mit einer Energie unterhalb einer Grenzenergie vom Teilchenstrahl abgezogen oder abgetrennt (abgesaugt) werden und nur Teilchen mit höherer Energie zum Detektormittel durchgelassen werden. Aufgrund der erfindungsgemäßen Umwandlung des Teilchenstrahls in einen Parallelstrahl ist es möglich, die teildurchlässigen Elektroden mit einer im wesentlichen ebenen Gestalt zu versehen und so im Parallelstrahl anzuordnen, daß dieser im wesentlichen senkrecht auf die teildurchlässigen Elektroden trifft.

Die erreichbare Empfindlichkeit ist von der Bauform der Filterelektroden und ihren Betriebsparametern, insbesondere von der Größe des Abbremsfeldes und den Gitteröffnungen, abhängig. Da in der Nähe der Gitterelemente in Abhängigkeit vom Potential Feldverzerrungen auftreten, die die Durchlässigkeit beeinflussen und die Energieselektivität storen, werden grundsätzlich große Gitteröffnungen (300 µm und kleiner) bevorzugt.

Nach Durchlaufen der Filterelektroden erfolgt die Abbildung auf ein Detektorelement. Das Detektorelement wird durch einen flächigen Teilchenauffänger gebildet, der zur ortsabhängigen Erfassung der eintreffenden Teilchenströme eingerichtet ist. Der Teilchenauffänger ist vorzugsweise ein Leuchtschirm, der mit einem optischen Detektor, z. B. einer Photodiodenanordnung, einer CCD-Kamera oder einer sog. Channelplate, gekoppelt ist. Es kann aber ersatzweise auch eine Anodenmatrix vorgesehen sein, der im Falle der Untersuchung von Ionenstrahlen geeignete Elektronenvervielfacher vorgeschaltet sind (Channeltron). Der Teilchenstrahl kann auf dem Abstand von den Filterelektroden zum Detektorelement beschleunigt werden. Es ist jedoch auch ein feldfreier Raum möglich. Das Detektorelement kann sogar abstandsfrei (z. B. als Kanalplatte) integral mit der letzten Filterelektroden verbunden sein.

Die Abbremslinse, die Filterelektroden und das Detektorelement sind vorzugsweise gemeinsam gehaltert. Die Größe eines äußeren Gehäuses ist beliebig an die Bauform der Komponenten anzupassen.

Es wird die Anpassung an einen Standardflansch (Durchmesser 100 mm oder 150 mm) bevorzugt. Der Aufbau ist vorzugsweise rotationssymmetrisch, wobei jedoch die Filterelektroden eckig gebildet sein können.

Ein erfindungsgemäßes Spektrometer ist mit einem oben beschriebenen Gegenfeldanalysator versehen. Es wird vorzugsweise mit zwei Meßkanälen betrieben, deren Empfindlichkeit und dynamisches Verhalten an die jeweilige Erfassung der Winkelverteilung und der Energieverteilung angepaßt sind.

Die erfindungsgemäßen Meßverfahren umfassen die energieselektive Beobachtung der Abbildung des Teilchenstrahlquerschnitts (z. B. eines Beugungsbild) vorzugsweise als Echtzeituntersuchung während eines Wachstumsvorgangs auf der Oberfläche eines Festkörpers, die Aufnahme von ortsaufgelösten Energieverlustspektren oder Augerelektronen-Spektren oder die Durchführung herkömmlicher Beugungsuntersuchungen (z. B. RHEED) mit Gesichtsfeldveränderung.

Erfindungsgemäße Vorrichtungen und ihr Einsatz in spektroskopischen Meßverfahren besitzen die folgenden Vorteile.

Ein großer Arbeitsabstand ermöglicht, daß die Filterelektroden und das Detektorelement genügend weit von der Probe angeordnet werden können, so daß keine Platzprobleme in bezug auf weitere Komponenten einer Meßanordnung bestehen. Die Bildung eines Parallelstrahls vereinfacht die Abbildung auf einem Detektor. Daher kann auf abbildungskorrigierende Filterelektroden verzichtet und eine entsprechende Verringerung der Transmissivität vermieden werden.

Sowohl der Abstand des Detektors zur Probe als auch der Arbeitsabstand ist durch geeignet angepaßte Potentiale der Ablenkmittel frei wählbar. Erfindungsgemäße Systeme sind durch Potentialänderungen einfach an verschiedene Probenlagen anpaßbar.

Insbesondere bei in situ-Messungen an einer MBE-Anlage sind alle Analysatorelemente außerhalb der Kammer anordenbar, wo kein störender Partialdruck der Verdampfer auftritt. Daher treten keine Verunreinigung auf, so daß eine erhöhte Zuverlässigkeit erreicht wird. Gleichzeitig ist mit den Ablenkmitteln eine Winkelkorrektur möglich, falls der Analysator in der MBE-Kammer nicht an einer optimaler Position angebracht werden kann (Justierung von Fehlausrichtungen).

Es ist erstmalig möglich, bei großem Arbeitsabstand eine Winkelanalyse selbst bei großen Winkeln des von der Probe ausgehenden primären Teilchenstrahls im Bereich 15 bis 20° vorzunehmen.

Die Ablenkmittel ermöglichen eine Auswahl des tatsächlich erfaßten Gesichtsfeldes. Durch eine einfache Variation der Spannung der Abbremslinsen läßt sich eine Zoom-Wirkung erzielen.

Die Bereitstellung eines abgebremsten Parallelstrahls erlaubt den Einsatz von größeren Gitteröffnungen an den Filterelektroden. Damit wird die Transmissivität der Gesamtabbremsanordnung bis rund 80 % erhöht, so daß sich eine größere Empfindlichkeit ergibt. Ferner sind Filterelektroden mit größeren Gitteröffnungen gut herstellbar und handhabbar und durch eine hohe Zuverlässigkeit gekennzeichnet.

Erfindungsgemäße Vorrichtungen erlauben hervorragende Energieauflösungen im Bereich 10⁻⁴. So lassen sich in einem Primärstrahl von 15 keV noch Energieverteilungen mit charakteristischen Breiten von 2 eV auflösen. Die Energieauflösung ist durch die Potentiale der Ablenkmittel beeinflußbar. Die Energieauflösung ist proportional zur Feldstärke in der energieselektiven Elektrodenanordnung. Hohe Feldstärken verursachen größere Energiebreiten bzw. eine geringere Auflösung.

Die Ausführung des Detektors z. B. als Kombination eines Leuchtschirms mit einer CCD-Kamera oder Channelplate erlaubt einen Betrieb mit geringsten Elektronenströmen.

Die Anwendung der Erfindung bezieht sich auf die Analyse beliebiger geladener Teilchen und ist nicht auf Elektronenbeugungsuntersuchungen beschränkt.

Ausführungsformen der Erfindung werden unter Bezugnahme auf die beiliegenden Zeichnungen beschrieben. Es zeigen:
Fig. 1: eine Ausführungsform einer erfindungsgemäßen Vorrichtung in Schnittansicht,
Fig. 2: eine Ausführungsform eines erfindungsgemäßen Spektrometers (teilweise geschnitten),
Fig. 3: ein Beispiel einer RHEED-Apparatur mit einem erfindungsgemäßen Spektrometers,
Fig. 4: eine weitere Ausführungsform einer erfindungsgemäßen Vorrichtung in drei schematischen Schnittansichten zur Erläuterung der Bildverschiebung;
Fign. 5a, 5b: Kurvendarstellungen zur Illustration der Energieauflösung eines erfindungsgemäßen Spektrometers (a) bzw. eines Energieverlust-Spektrums (b), das mit einem erfindungsgemäßen Spektrometer gemessen wurde, und
Fig. 6: eine Schnittansicht von Kugelgittern in einer RHEED-Apparatur gemäß dem Stand der Technik.

Die im folgenden erläuterten Ausführungsbeispiele zeigen erfindungsgemäße Vorrichtungen beispielhaft in kompakter Bauform. Die Erfindung ist jedoch nicht auf die kompakte Bauform beschränkt. Es ist vielmehr auch möglich, in axialer Richtung längere Bauformen zu realisieren, falls beispielsweise die Probe aufgrund ihrer Temperatur oder zur Vermeidung von Verunreinigungen möglichst weit vom Detektor entfernt sein soll.

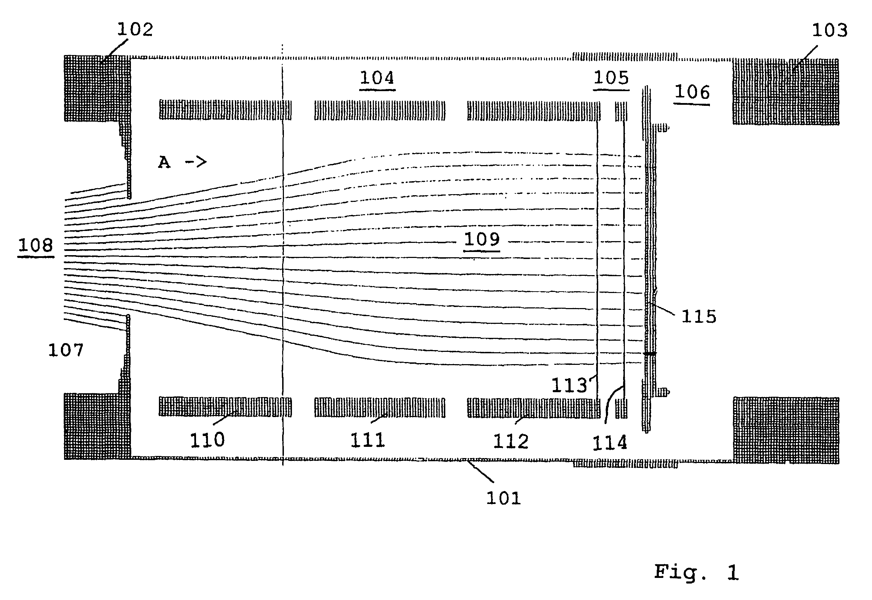

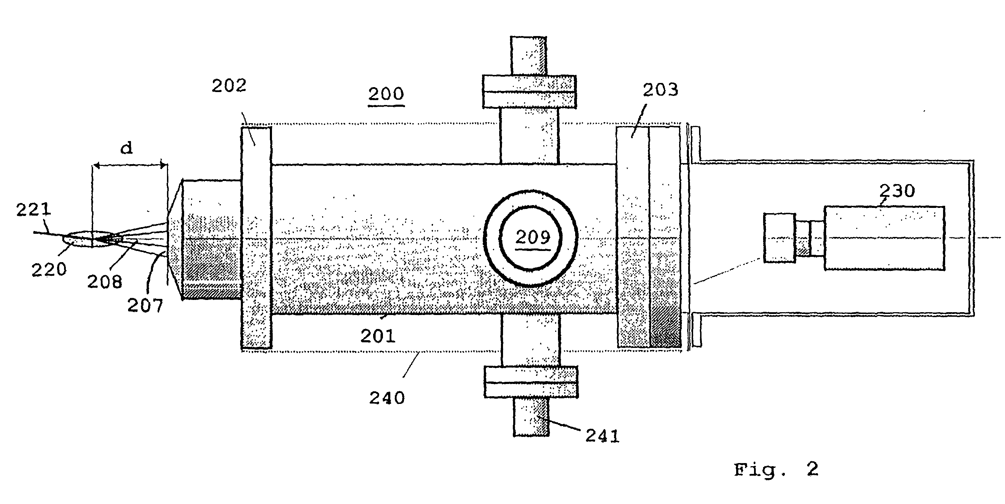

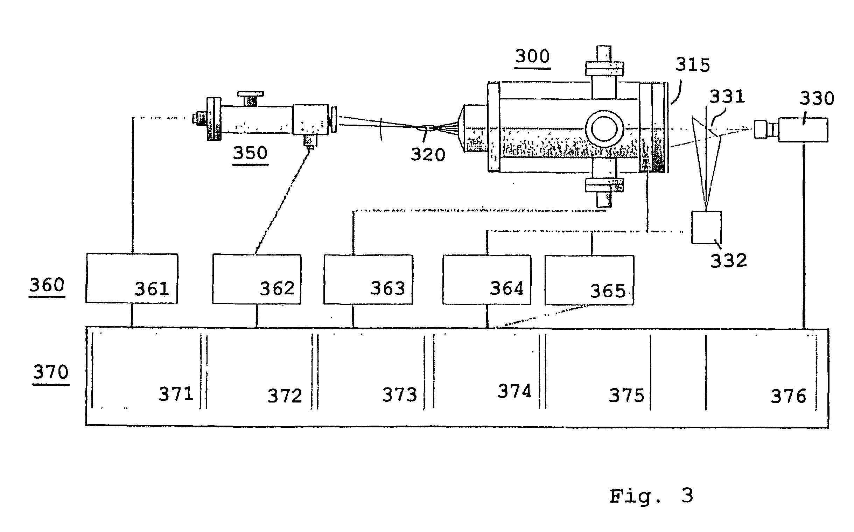

Figur 1 zeigt eine Schnittansicht eines erfindungsgemäßen Analysatoraufbaus 100 zur auflösenden Abbildung eines Elektronenstrahls mit einer bestimmten Energie- und Winkelverteilung. Ein Gehäuse 101 in Form eines Zylinders, der an seinen Enden Halterungsmittel 102, 103 aufweist, enthält einen Ablenkbereich 104, einen Filterbereich 105 und einen Detektorbereich 106. Die Ablenkmittel im Ablenkbereich 104 werden durch Abbremslinsen 110, 111 und 112 gebildet. Der Filterbereich 105 enthält die Filterelektroden 113 und 114, die durch im wesentlichen ebene, gitterförmige Elektrodennetze gebildet werden. Das Detektorelement im Detektorbereich 106 ist ein Leuchtschirm 115, der mit geeigneten Sensormitteln (nicht dargestellt) zusammenwirkt. Die Sensormittel können eine CCD-Kamera, eine Photodiode und/oder einen Elektronenvervielfacher umfassen (siehe Fign. 2, 3). Die Versorgungsleitungen und Halterungen der einzelnen Komponenten sind nicht dargestellt. Der Leuchtschirm 115 ist zur Vermeidung von Aufladungen elektrisch leitend. Für sehr empfindliche Messungen mit geringen Strömen kann der Leuchtschirm durch einen Channelplate Elektronenvervielfacher ersetzt werden. Der Leuchtschirm wird dann hinter der Channelplate angebracht.

Im Betriebszustand tritt durch die Eintrittsöffnung 107 ein Elektronenstrahl 108 in das Gehäuse 100 ein. Der Elektronenstrahl 108 ist beispielsweise ein Bündel (Strahl) von Elektronen, die nach Streuung an einer Probenoberfläche divergente Teilchenbahnen bilden. In der Darstellung sind die Bahnen durch Linien gezeigt, die jeweils eine Abstufung von 1° pro Linie besitzen. Die Eintrittsöffnung 107 bildet eine Blende, mit der ein Teil des gestreuten Bündels erfaßt wird. Der erfaßte Elektronenstrahl enthält eine Winkelverteilung von gestreuten Elektronen, die als Elektronenstromverteilung durch eine Ebene, die vom Elektronenstrahl geschnitten wird, z. B. die Ebene der Eintrittsöffnung 107, darstellbar ist. Die Elektronen bewegen sich unter dem Einfluß der von den Abbremslinsen 110, 111 und 112 ausgehenden Felder in Richtung des Pfeiles A, wobei ein Bündel von Elektronen (Elektronenstrahl 109) mit im wesentlichen parallelen, geraden Teilchenbahnen geformt wird. Der Elektronenstrahl 109 bildet eine der ursprünglichen Winkelverteilung entsprechende Elektronenstromverteilung durch eine Ebene senkrecht zur Bewegungsrichtung A.

Der Elektronenstrahl 109 trifft auf eine erste Filterelektrode 113, die das selbe Potential aufweist wie die Abbremslinse 112. Die Gitteröffnungen der ersten Filterelektrode 113 besitzen eine Größe von rund 300 um, können aber auch kleiner sein. Die durch die Gitteröffnungen hindurchtretenden Elektronen laufen gegen ein Filter-Bremspotential zur zweiten Filterelektrode 114, die vorzugsweise die gleichen geometrischen Eigenschaften besitzt wie die erste Filterelektrode 113.

Die Elektronen, die eine genügend hohe Energie aufweisen, um gegen das Bremspotential durch die Gitteröffnungen der zweiten Filterelektrode 114 hindurchzutreten, treffen auf den Leuchtschirm 115. Zwischen dem Leuchtschirm 115 und der zweiten Filterelektrode 114 ist ein Beschleunigungspotential gebildet.

Beispielwerte für die Potentiale der Abbremslinsen 110, 111 und 112 sind jeweils entsprechend -10,3 kV, -17,4 kV und -17,5 kV (Gehäuse auf Masse). Die Abbremslinse 112 ist zur Randstrahlkorrektur vorgesehen. Durch Einstellung dieser Potentialbeträge kann bestimmt werden, wie groß ein Ausschnitt des durch die Eintrittsöffnung 107 durchgelassenen Elektronenstrahls ist, der auf die erste Filterelektrode 113 trifft, d. h. wie groß das Gesichtsfeld des Detektorelements ist. Es können seitliche Auffangelektroden zur Aufnahme des Teils des Strahls vorgesehen sein, der nicht in das Gesichtsfeld fällt.

Das Potential der zweiten Filterelektrode 114 kann z. B. auf -20 kV liegen, ist aber für die meisten Anwendungen mit einem Einstellmittel (nicht dargestellt) variabel, um eine bestimmte Energieselektion zu ermöglichen. Der Leuchtschirm 115 kann ein Potential von rd. 19 kV aufweisen.

Durch das Potential der zweiten Filterelektrode 114 wird eine Grenzenergie bestimmt. Elektronen mit einer Energie kleiner oder gleich der Grenzenergie sind nicht in der Lage, das Bremspotential zu durchlaufen. Elektronen mit einer höheren Energie erreichen das Beschleunigungspotential zum Leuchtschirm. Aufgrund dieser Eigenschaft ist das Bremspotential ein Filterpotential mit Hochpaßeigenschaften.

Figur 2 zeigt eine Ausführungsform eines erfindungsgemäßen Spektrometers 200 (Meßteil, ohne Steuerung u. dgl.), das in einem zylindrischen Gehäuse 201 einen Analysatoraufbau gemäß Figur 1 enthält.

Die Probe 220 wird streifend von einem Primärstrahl 221 getroffen. Der abgebeugte Elektronenstrahl 208 mit divergenten Bahnen tritt durch die Eintrittsöffnung 207 in den Analysatoraufbau, wird mit den (nicht dargestellten) Ablenkmitteln in einen Strahl 209 mit parallelen Bahnen umgeformt, mit den (nicht dargestellten) Filterelektroden gefiltert und auf einen Leuchtschirm oder Bildverstärker abgebildet, der mit einer Videokamera 230 erfaßt wird.

Das Gehäuse 201 trägt an den Halterungsmitteln 202 und 203 eine äußere metallische Abschirmung 240. Das Halterungsmittel 202 kann z. B. ein an eine Vakuumkammer anpaßbarer Flansch sein. An der Seite des Gehäuses 201 sind Flansche 241 für elektrische Versorgungs- und Steuerleitungen vorgesehen.

Der Arbeitsabstand d zwischen der Probe 220 und der Eintrittsöffnung 207 ist variabel und kann zwischen 50 bis 100 mm betragen.

Figur 3 zeigt eine RHEED-Apparatur mit einer RHEED-Elektronenstrahlquelle 350, einem erfindungsgemäßen Spektrometer 300, Steuerungselementen 360 und einer Datenverarbeitungseinheit 370. Die Elektronenstrahlquelle 350 ist zur Bestrahlung der Probe 320 vorgesehen. Das gestreute Elektronenbündel wird vom Spektrometer 300 erfaßt, das im wesentlichen der Bauform gemäß Figur 2 entspricht.

Bei der Ausführungsform gemäß Figur 3 wird der Analysator mit zwei Meßkanälen simultan betrieben. Das durch die Filtervorrichtung durchgelassene Beugungsbild auf dem Leuchtschirm 315 wird mit einem optischen System erfaßt, das einen Strahlteiler 331 enthält. Der Strahlteiler 331 erlaubt einerseits die Bilderfassung mit einem zweidimensionalen Detektor, z. B. einer CCD-Kamera 330, und andererseits die Erfassung eines Signals, das der integralen Leuchtdichte des Beugungsbildes entspricht, mit einem schnell ansprechenden, dynamischen Sensor 332, z. B. einer Photodiode oder einem Photomultiplier. Dies hat den Vorteil, das die Bilderfassung mit einer relativ langsamen Kamera erfolgen kann.

Einzelheiten des optischen Systems (Linse etc.) sind nicht dargestellt.

Die schnelle Integralmessung mit einem hohen Dynamikbereich hingegen erlaubt eine Lock-in-Messung, die sich durch ein niedriges Signal-Rausch-Verhältnis und die unmittelbare Aufnahme von Energieverlustspektren auszeichnet. Eine Modulation des Filtergitter-Abbremspotentials erlaubt die Erfassung von Elektronenströmen, die entsprechend der Energie der durchgelassenen Elektronen im Zeitverlauf moduliert sind. Da die Abbremsgitteranordnung als Filterstufe einen Hochpaß darstellt, können über die Zeitableitungen der Elektronenströme somit unmittelbar Energieverlustspektren aufgenommen werden.

Steuerungselemente 360, 370 der RHEED-Apparatur sind in Figur 3 als Blockschaltbild dargestellt. Die Steuerungselemente 360 umfassen eine Versorgungseinheit 361 der Elektronenstrahlquelle 350, eine Ablenkeinheit 362 für die Elektronenstrahlquelle 350, eine Spektrometersteuereinheit 363, ein Lock-in-System 364 und einen Stromverstärker 365. Die Datenverarbeitungseinheit 370 vorzugsweise in Form einer Computersteuerung umfaßt eine Schaltung 371 zur Bereitstellung der Steuersignale für die Versorgungseinheit 361, eine Schaltung 372 zur Vorgabe von Bestrahlungsparametern, eine Schaltung 373 zur Lieferung von Spektrometersteuersignalen, eine Schaltung 374 zur Lock-in-Datenaufnahme, eine Schaltung 375 zur Steuerung von Wachstumsvorgängen mittels einer (nicht dargestellten) MBE-Apparatur und eine Schaltung 376 zur Bildverarbeitung und -anzeige. Die Schaltung 374 zur Lock-in-Datenaufnahme enthält eine schnelle 16-Bit-Datenaufnahme.

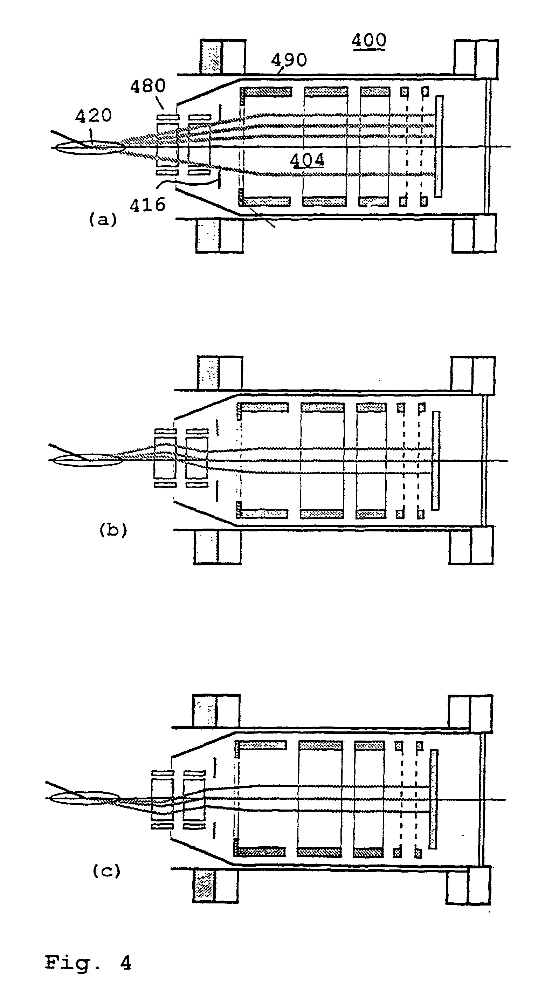

Die oben genannte Zoom-Wirkung nach Variation der Spannung der Abbremslinsen ist wegen der Linsensymmetrie axial. Um den abgebildeten Probenabschnitt auch außeraxial variieren (Bildverschiebungen) zu können, kann ein erfindungsgemäßes System zusätzlich mit Bildverschiebungsmitteln ausgerüstet sein, die in Figur 4 mit drei schematischen Schnittansichten illustriert sind. Figur 4 zeigt einen Analysatoraufbau 400, der im wesentlichen dem Analysatoraufbau 100 gemäß Figur 1 entspricht, mit einem äußeren Gehäuse 490.

Die Bildverschiebungsmittel 480 in Form mindestens einer weiteren Ablenkeinheit sind zwischen der Probe 420 und der Eintrittsöffnung 402 angeordnet. Es sind vorzugsweise zwei Ablenkeinheiten 480a, 480b vorgesehen, da bei zweifacher Ablenkung bereits bei der Bildverschiebung eine Parallelisierung möglich ist. Die Ablenkeinheiten sind zur magnetischen Strahlbeeinflussung eingerichtet, da mit Magnetfeldern kleinere Bildfehler erzielbar sind. Bei Verwendung von Magnetspulen müssen diese mit geeignet gewählten Materialien vakuumgerecht aufgebaut sein. Es sind aber auch elektrische Ablenkeinheiten (elektrostatische Ablenkplatten) möglich. Zwischen den Ablenkeinheiten 480 und der Eintrittsöffnung 402 kann zusätzlich eine Blende 416 zur Strahlbegrenzung vorgesehen sein.

Die Figuren 4a, 4b und 4c zeigen schematisch jeweils entsprechend eine Abbildung ohne Bildverschiebung (a, entspricht Fig. 1), mit Bildverschiebung nach unten (b) und mit Bildverschiebung nach oben (c).

Durch geeignet gewählte Ansteuerung der Bildverschiebungsmittel 480 und der Ablenkmittel 404 ist die Wahl eines Bildausschnitts der betrachteten Probe vorteilhafterweise mit der Zoom-Wirkung kombinierbar.

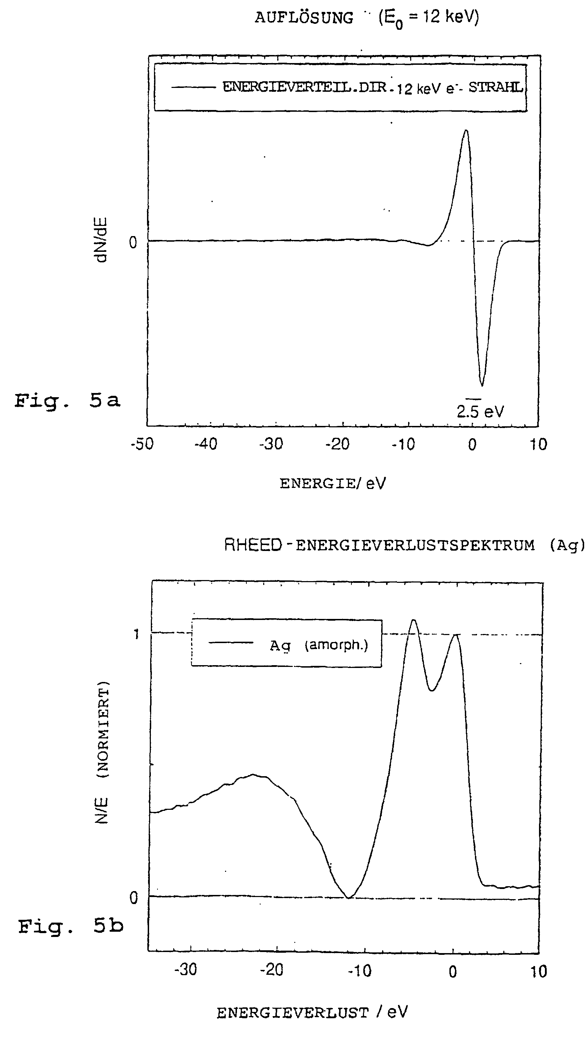

Wichtige Vorteile eines erfindungsgemäßen Analysatoraufbaus sind aus den Figuren 5a und 5b ersichtlich. Figur 5a zeigt die erste Ableitung der Intensität-Energie-Funktion eines 12 keV- Elektronenstrahls. Die Halbwertsbreite der Intensitätsverteilung (Abstand der Umkehrpunkte) beträgt 2,5 eV, was einer hervorragenden Energieauflösung von rund 2·10⁻⁴ entspricht. Das in Figur 5b dargestellte Energieverlust-Spektrum einer Silberprobe zeigt getrennte Maxima bei 4 eV und 23 eV. Die Lage der Maxima ist substanzspezifisch, so daß mit einem erfindungsgemäßen Spektrometer hochgenaue chemische Analysen auf Materialoberflächen durchführbar sind.

Erfindungsgemäß sind herkömmliche Analyseverfahren mit Winkelund Energieauflösung dahingehend modifizierbar, daß vor der Aufnahme von Beugungsbildern oder von Energieverlust-Spektren zunächst ein Auswahlschritt erfolgt, mit dem ein interessierender Bereich des Gesichtsfeldes ausgewählt und dann analysiert wird. Eine bevorzugte Anwendung der Erfindung ist die Echtzeitbeobachtung von Beschichtungs- oder Adsorptions- oder Abtragsvorgängen in Vakuumbeschichtungsanlagen, z. B. in MBE-Kammern.

Die Erfindung kann ferner vorteilhaft bei den folgenden Systemen eingesetzt werden: RHEED-Vorrichtungen mit Energiefilterung zur Trennung elastischer und unelastischer Streuungen oder zur Eliminierung von Kikuchi-Linien, Ionenspektrometer und Massenspektrometer, beliebige winkelauflösende Energieanalysatoren, und elektronenspektroskopische Holographie. Eine wichtige Anwendung der Erfindung bezieht sich auf die Ionen-Streu-Spektroskopie (Ion Scattering Spectroscopy, ISS). Dabei wird die Energieverteilung rückgestreuter Ionen für einen bestimmten, möglichst kleinen Winkel gemessen. Die Erfindung erlaubt nun die gleichzeitige Energie- und Winkelmessung. Bei der Oberflächenholographie wird die Winkelverteilung diffus gestreuter Elektronen gemessen. Strukturen der Verteilung werden nach numerischer Bearbeitung interpretiert und weisen auf holographische Effekte hin, die durch Adsorbate oder Strukturen auf der Oberfläche hervorgerufen werden.

## Patentansprüche

1. Vorrichtung (100,400) zur Abbildung eines Teilchenstrahls (109), der geladene Teilchen mit einer bestimmten Energie- und Winkelverteilung umfasst, auf einem Detektormittel (106), wobei die Vorrichtung teildurchlässige Filterelektroden (105) aufweist, die mit einer Potentialdifferenz zur Bildung eines Abbremsfeldes beaufschlagbar und dazu eingerichtet sind, für die Teilchen energieselektiv durchlässig zu sein,
**dadurch gekennzeichnet, dass**
eine Ablenk- und Abbremseinrichtung (104, 404) mit mindestens einer potentialbeaufschlagten Abbremslinse (110,111,112) vorgesehen ist, die dazu eingerichtet ist, den Teilchenstrahl vor Erreichen der Filterelektroden (105) abzubremsen und im Teilchenstrahl im wesentlichen parallele Teilchenbahnen auszubilden, deren gegenseitigen Abstände der Winkelverteilung der Teilchen entsprechen und die auf die Filterelektroden (105) gerichtet sind.

2. Vorrichtung gemäß Anspruch 1, bei der mehrere Abbremslinsen (110,111,112) vorgesehen sind, die in Ausbreitungsrichtung des Teilchenstrahls steigende Abbremspotentiale aufweisen.

3. Vorrichtung gemäß einem der vorhergehenden Ansprüche, bei der die Filterelektroden im wesentlichen ebene Gitterelektroden (113,114) sind, die so angeordnet sind, dass der Teilchenstrahl mit den parallelen Teilchenbahnen im wesentlichen senkrecht zu den Ebenen der Gitterelektroden (113,114) ausgerichtet ist.

4. Vorrichtung gemäß einem der vorhergehenden Ansprüche, bei der die Filterelektroden erste und zweite Filterelektroden (113,114) umfassen, zwischen denen ein Filter-Abbremspotential anliegt, dessen Betrag eine Grenzenergie bestimmt.

5. Vorrichtung gemäß einem der vorhergehenden Ansprüche, bei der die Detektormittel einen Abbildungsschirm (115) zur Bildung eines optischen Bildes und Sensormittel zur Erfassung des optischen Bildes enthalten.

6. Vorrichtung gemäß Anspruch 5, bei der die Sensormittel eine Bildaufnahmeeinrichtung und einen Sensor zur Erfassung eines Signals enthalten, das der integralen Bildhelligkeit entspricht.

7. Vorrichtung gemäß einem der vorhergehenden Ansprüche, bei der die Abbremspotentiale der Abbremslinsen und das Filter-Abbremspotential für die Abbildung von Elektronen, Ionen, Ionengruppen oder geladenen Atom- oder Molekülgruppen eingerichtet sind.

8. Spektrometer (200,300), das eine Vorrichtung (100,400) gemäß einem der Ansprüche 1 bis 7 aufweist.

9. Verfahren zur Abbildung eines Teilchenstrahls (109), der geladene Teilchen mit einer bestimmten Energie- und Winkelverteilung umfasst, auf einem Detektormittel (106), wobei der Teilchenstrahl teildurchlässige Filterelektroden (105) durchläuft, die mit einer Potentialdifferenz zur Bildung eines Abbremsfeldes beaufschlagt sind, um Teilchen energieselektiv durchzulassen,
**dadurch gekennzeichnet, dass**
im Teilchenstrahl durch eine Ablenk- und Abbremseinrichtung (104,404) mit mindestens einer potentialbeaufschlagten Abbremslinse (110,111,112) eine Abbremsung der Teilchen erfolgt und im wesentlichen parallele Teilchenbahnen ausgebildet werden, deren gegenseitige Abstände der Winkelverteilung der Teilchen entsprechen und die auf die Filterelektroden (105) gerichtet sind.

10. Verfahren gemäß Anspruch 9, bei dem Bildverschiebungsmittel (480) und die Ablenk- und Abbremseinrichtung so angesteuert werden, dass ein vorbestimmter Ausschnitt des Teilchenstrahls auf die Filterelektroden (105) trifft.

11. Verwendung einer Vorrichtung (100,200,300,400) gemäß einem der Ansprüche 1 bis 8 zur Analyse von Festkörperoberflächen in Vakuumbeschichtungsanlagen, für RHEED-Untersuchungen, zur Aufnahme von Energieverlust- oder Augerelektronen-Spektren, für massenspektroskopische Untersuchungen, oder für oberflächenholographische Messungen.

## Claims

1. Apparatus (100,400) for imaging a particle beam (109), which comprises charged particles having a specific energy distribution and angle distribution, on a detector (106), said apparatus having semi-transmissive filter electrodes (105) to which a potential difference can be applied to form a deceleration field and which are arranged to allow the particles to pass through by means of energy selectivity,
**characterised in that**
a deflection and deceleration device (104,404) is provided having at least one stop lens (110,111, 112) to which potential is applied and which is arranged to decelerate the particle beam before it reaches the filter electrodes (105) and to form in the particle beam substantially parallel particle paths, the mutual spacing of which corresponds to the angle distribution of the particles and which are directed towards the filter electrodes (105).

2. Apparatus according to claim 1, wherein a plurality of stop lenses (110,111,112) are provided which have deceleration potentials which increase in the direction of propagation of the particle beam.

3. Apparatus according to one of the preceding claims, wherein the filter electrodes are substantially planar grid electrodes (113,114) which are so disposed that the particle beam with the parallel particle paths is aligned substantially perpendicular to the planes of the grid electrodes (113,114).

4. Apparatus according to one of the preceding claims, wherein the filter electrodes comprise first and second filter electrodes (113,114) between which there is a filter stop potential, the amount of which determines an energy threshold.

5. Apparatus according to one of the preceding claims, wherein the detector means contain an imaging screen (115) to form an optical image and sensor means to detect the optical image.

6. Apparatus according to claim 5, wherein the sensor means contain an image recording device and a sensor to detect a signal which corresponds to the integral luminosity of the image.

7. Apparatus according to one of the preceding claims, wherein the deceleration potentials of the stop lenses and the filter stop potential are arranged for the imaging of electrons, ions, clusters of ions or clusters of charged atoms or molecules.

8. Spectrometer (200,300) which has an apparatus (100,400) according to one of claims 1 to 7.

9. Method of imaging a particle beam (109) which comprises particles having a specific energy distribution and angle distribution, on a detector (106), the particle beam passing through semi-transmissive filter electrodes (105) to which a potential difference is applied to form a deceleration field, in order to allow particles to pass through by means of energy selectivity,
**characterised in that**
in the particle beam, the particles are decelerated by a deceleration and deflection device (104,404) having at least one stop lens (110,111,112) to which potential is applied and substantially parallel particle paths are formed, the mutual spacing of which corresponds to the angle distribution of the particles and which are directed towards the filter electrodes (105).

10. Method according to claim 9, wherein image displacement means (480) and the deflection and deceleration device are so controlled that a predetermined portion of the particle beams impinges on the filter electrodes (105).

11. Use of an apparatus (100,200,300,400) according to one of claims 1 to 8 to analyse the surface of solid bodies in vacuum-coating plants, for RHEED tests, to record energy-loss spectra or Auger electron spectra, for tests using mass spectroscopy, or for surface holography measurements.

## Revendications

1. Appareil (100, 400) pour reproduire un rayon de particules (109) constitué de particules chargées avec une distribution d'énergie et une répartition angulaire déterminées, sur un détecteur (106), où l'appareil comporte des électrodes filtrantes (105) à l'état semi-passant, dotées d'une différence de potentiel pour former un champ de freinage et disposées de manière à laisser passer les particules en fonction de l'énergie, **caractérisé en ce qu'**il prévoit un dispositif de déviation et de freinage (104, 404) avec au moins une lentille de freinage alimentée en potentiel (110, 111, 112), disposée de manière à freiner le rayon de particules avant qu'il n'atteigne les électrodes filtrantes (105) et à former, dans le rayon de particules, des trajectoires de particules parallèles pour l'essentiel dont l'écart mutuel correspond à la répartition angulaire des particules et qui sont dirigées sur les électrodes filtrantes (105).

2. Appareil selon la revendication 1, dans lequel plusieurs lentilles de freinage (110, 111, 112) sont prévues, présentant des potentiels de freinage croissants dans le sens de propagation du rayon de particules.

3. Appareil selon l'une quelconque des revendications précédentes, dans lequel les électrodes filtrantes sont essentiellement des électrodes plates à grilles (113, 114), placées de façon à ce que le rayon de particules aux trajectoires parallèles de particules soit orienté pour l'essentiel perpendiculairement aux électrodes à grilles (113, 114).

4. Appareil selon l'une quelconque des revendications précédentes, dans lequel les électrodes filtrantes comprennent la première et la deuxième électrodes filtrantes (113, 114) entre lesquelles se trouve un potentiel de freinage des filtres dont la valeur détermine une énergie limite.

5. Appareil selon l'une quelconque des revendications précédentes, dans lequel les détecteurs comprennent un écran de reproduction (115) pour y former une image optique et des éléments sensibles pour détecter l'image optique.

6. Appareil selon la revendication 5, dans lequel les éléments sensibles comprennent un dispositif de prise de vue et un capteur pour détecter un signal correspondant à la luminosité intégrale de l'image.

7. Appareil selon l'une quelconque des revendications précédentes, dans lequel le potentiel de freinage des lentilles de freinage et le potentiel de freinage des filtres pour la reproduction d'électrons, d'ions, de groupes d'ions ou de groupes d'atomes ou de molécules chargés, sont disposés.

8. Spectromètre (200, 300) comportant un appareil (100, 400) selon l'une quelconque des revendications 1 à 7.

9. Procédé pour la reproduction d'un rayon de particules (109) constitué de particules chargées avec une distribution d'énergie et une répartition angulaire déterminées, sur un détecteur (106), dans lequel le rayon de particules traverse des électrodes filtrantes (105) à l'état semi-passant, dotées d'une différence de potentiel pour former un champ de freinage, de manière à laisser passer les particules en fonction de l'énergie, **caractérisé en ce qu'**un freinage des particules se produit par l'action d'un dispositif de déviation et de freinage (104, 404) avec au moins une lentille de freinage alimentée en potentiel (110, 111, 112) et que se forment des trajectoires de particules parallèles pour l'essentiel dont l'écart mutuel correspond à la répartition angulaire des particules et qui sont dirigées sur les électrodes filtrantes (105).

10. Procédé selon la revendication 9, dans lequel des moyens de décalage de l'image (480) et le dispositif de déviation et de freinage sont commandés de façon à ce qu'une portion prédéfinie du rayon de particules rencontre les électrodes filtrantes (105).

11. Utilisation d'un appareil (100, 200, 300, 400) selon l'une quelconque des revendications 1 à 8, pour l'analyse de surfaces de solides dans des installations recouvertes de vide, pour des essais RHEED, pour l'enregistrement de spectres de perte d'énergie ou d'électrons Auger, pour des essais de spectroscopie de masse ou pour des mesures holographiques de surfaces.
